# FASCICULE DE BREVET EUROPEEN

(11) **EP 2 828 888 B1**
(45) Date de publication et mention de la délivrance du brevet: **05.06.2019**
(21) Numéro de dépôt: 13715356.5
(22) Date de dépôt: 20.03.2013
(51) Int. Cl.: H01L 21/98, H01L 21/58, H01L 21/48, H01L 23/14, H01L 23/13

(54) **PROCÉDÉ COMPRENANT LA FABRICATION D'AU MOINS UN PLOT D'ASSEMBLAGE SUR UN SUPPORT ET L'AUTO-ASSEMBLAGE D'UNE PUCE DE CIRCUIT INTEGRÉ SUR LE SUPPORT AVEC FORMATION D'UN MATÉRIAU FLUOROCARBONÉ ENTOURANT LE PLOT ET EXPOSITION DU PLOT ET DU MATÉRIAU FLUOROCARBONÉ À UN TRAITEMENT ULTRAVIOLET EN PRÉSENCE D'OZONE**
VERFAHREN AUFWEISEND HERSTELLUNG VON MINDESTENS EINEM MONTAGEPAD AUF EINEM TRÄGER UND SELBSTASSEMBLIERUNG EINES CHIPS MIT INTEGRIERTEN SCHALTUNGEN AUF DEM TRÄGER MIT BILDUNG EINES FLUORKOHLENSTOFFMATERIALS UM DAS MONTAGEPAD HERUM UND EXPOSITION DES MONTAGEPADS UND DES FLUORKOHLENSTOFFMATERIALS ZU UV-BEHANDLUNG IN ANWESENHEIT VON OZON
METHOD COMPRISING PRODUCING AT LEAST ONE ASSEMBLY PAD ON A SUPPORT AND SELF-ASSEMBLY OF AN INTEGRATED CIRCUIT CHIP ON THE SUPPORT WITH FORMATION OF A FLUOROCARBON MATERIAL SURROUNDING THE PAD AND EXPOSURE OF THE PAD AND OF THE FLUOROCARBON MATERIAL TO ULTRAVIOLET TREATMENT IN THE PRESENCE OF OZONE

(30) Priorité: 22.03.2012 FR 1252577
(43) Date de publication de la demande: 28.01.2015
(73) Titulaire: Commissariat à l'Énergie Atomique et aux Énergies Alternatives, 75015 Paris (FR); STMicroelectronics (Crolles 2) SAS, 38920 Crolles (FR)
(72) Inventeur: DI CIOCCIO, Léa, 38330 Saint Ismier (FR); MERMOZ, Sébastien, 38240 Meylan (FR); SANCHEZ, Loïc, 38500 Voiron (FR)
(74) Mandataire: Cabinet Beaumont
(86) Numéro de dépôt international: PCT/FR2013/050598
(87) Numéro de publication internationale: WO 2013/140094

(56) Documents cités:
- EP-A2- 1 478 016
- WO-A1-03/083960
- DE-B3-102009 050 426
- JP-A- 2005 014 141
- JP-A- 2011 227 814
- US-A1- 2009 265 929
- US-A1- 2010 073 452
- SYMS R A ET AL: "Surface Tension-Powered Self-Assembly of Microstructures - The State-of-the-Art", JOURNAL OF MICROELECTROMECHANICAL SYSTEMS, IEEE SERVICE CENTER, US, vol. 12, no. 4, août 2003 (2003-08), pages 387-417, XP011099390, ISSN: 1057-7157, DOI: 10.1109/JMEMS.2003.811724
- LEE S-H ET AL: "Silver inkjet printing with control of surface energy and substrate temperature", JOURNAL OF MICROMECHANICS & MICROENGINEERING, INSTITUTE OF PHYSICS PUBLISHING, BRISTOL, GB, vol. 18, no. 7, 2 juin 2008 (2008-06-02), pages 75014-1-75014-7, XP020136916, ISSN: 0960-1317, DOI: 10.1088/0960-1317/18/7/075014
- DEBRAY A ET AL: "Fluidic self-alignment applied to a micro-fluidic system", IEICE ELECTRONICS EXPRESS, vol. 3, no. 11, 10 juin 2006 (2006-06-10), pages 227-232, XP55030441, DOI: 10.1587/elex.3.227
- BAYIATI P ET AL: "Selective plasma-induced deposition of fluorocarbon films on metal surfaces for actuation in microfluidics", JOURNAL OF VACUUM SCIENCE AND TECHNOLOGY: PART A, AVS /AIP, MELVILLE, NY, US, vol. 22, no. 4, 20 juillet 2004 (2004-07-20), pages 1546-1551, XP012073771, ISSN: 0734-2101, DOI: 10.1116/1.1764815
- MATSUMOTO Y ET AL: "The property of plasma-polymerized fluorocarbon film in relation to CH4/C4F8 ratio and substrate temperature", SENSORS AND ACTUATORS A, ELSEVIER SEQUOIA S.A., LAUSANNE, CH, vol. 83, no. 1-3, 22 mai 2000 (2000-05-22) , pages 179-185, XP004198312, ISSN: 0924-4247, DOI: 10.1016/S0924-4247(99)00396-9
- SMITH B K ET AL: "Thin Teflon-like films for eliminating adhesion in released polysilicon microstructures", SENSORS AND ACTUATORS A, ELSEVIER SEQUOIA S.A., LAUSANNE, CH, vol. 70, no. 1-2, 1 octobre 1998 (1998-10-01), pages 159-163, XP004140127, ISSN: 0924-4247, DOI: 10.1016/S0924-4247(98)00127-7
- WONG I ET AL: "Surface molecular property modifications for poly(dimethylsiloxane) (PDMS) based microfluidic devices", MICROFLUIDICS AND NANOFLUIDICS, SPRINGER, BERLIN, DE, vol. 7, no. 3, 18 avril 2009 (2009-04-18), pages 291-306, XP019726804, ISSN: 1613-4990, DOI: 10.1007/S10404-009-0443-4
- MERMOZ S ET AL: "Impact of Containment and Deposition Method on Sub-Micron Chip-to-Wafer Self-Assembly Yield", 2011 IEEE INTERNATIONAL 3D SYSTEMS INTEGRATION CONFERENCE (3DIC), OSAKA, JAPAN, 31 JANVIER - 2 FÉVRIER 2012, IEEE, 31 January 2012 (2012-01-31), pages 1-5, XP032235019, DOI: 10.1109/3DIC.2012.6262953 ISBN: 978-1-4673-2189-1
- BIRCH W R: "Cleaning Glass Surfaces" In: AEGERTER M A ET AL: "SOL-GEL TECHNOLOGIES FOR GLASS PRODUCERS AND USERS", [Online] 2004, KLUWER ACADEMIC PUBLISHERS, BOSTON, XP009510605, ISBN: 978-1-4020-7938-2 pages 19-34, Retrieved from the Internet: URL:https://www.springer.com/de/book/97814 02079382>

## Description

### Domaine de l'invention

La présente invention concerne un procédé comprenant la fabrication d'au moins un plot sur un support et la mise en oeuvre d'un procédé d'auto-assemblage d'au moins une puce de circuit intégré sur le support.

### Exposé de l'art antérieur

Pour certaines applications, un circuit électronique ou plusieurs circuits électroniques, par exemple des circuits intégrés, sont fixés à un support. Le support correspond, par exemple, à un autre circuit intégré. La fixation est, par exemple, réalisée par collage moléculaire ou par thermocompression.

Avant de fixer le circuit intégré au support, il est nécessaire de placer correctement le circuit intégré par rapport au support. Ceci peut être réalisé par un procédé d'auto-assemblage du circuit intégré sur le support.

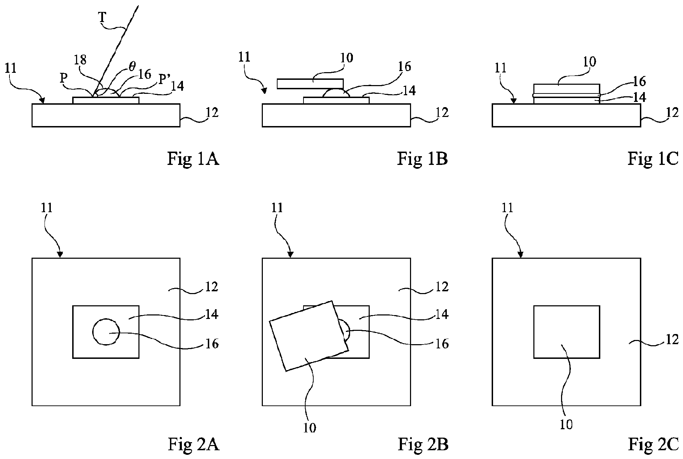

Les figures 1A à 1C sont des coupes, partielles et schématiques, des structures obtenues à des étapes successives d'un exemple de procédé d'auto-assemblage d'un circuit intégré 10 sur un support 11 et les figures 2A à 2C sont des vues de dessus respectivement des structures représentées aux figures 1A à 1C.

Le support 11 comprend un substrat 12 en un matériau à faible mouillabilité, par exemple du silicium, et comprend, en surface du substrat 12, un plot 14 d'un matériau à forte mouillabilité. Le support 11 peut comprendre plusieurs plots 14. Une goutte 16 d'un liquide, par exemple de l'eau déminéralisée, est disposée sur le plot 14 (figures 1A et 2A). Le plot 14 peut être réalisé en formant une couche d'oxyde de silicium sur le substrat 12 et en gravant la couche obtenue pour délimiter le plot 14. La couche d'oxyde de silicium peut avoir une épaisseur de l'ordre de 50 nm.

De façon générale, la mouillabilité d'un matériau peut être caractérisée par l'angle de contact θ d'une goutte de liquide sur le matériau. Plus l'angle de contact est faible, plus la mouillabilité du matériau est élevée. Dans le plan de coupe de la figure 1A, l'interface 18 liquide/air de la goutte 16 est en contact avec le plot 14 aux points de contact P et P'. On appelle T la tangente à l'interface 18 au point de contact P (ou P'). L'angle de contact θ de la goutte 16 sur le plot 14 est l'angle entre la tangente T et la surface du plot 14, la surface du plot 14 étant horizontale. Lorsque la goutte 16 est au repos, l'angle θ mesuré est l'angle de contact statique.

Le circuit électronique 10 est alors approché du plot 14 jusqu'à venir au contact de la goutte 16. Dans cette phase d'approche, le circuit intégré 10 peut être décalé et incliné par rapport au plot 14 (figures 1B et 2B).

Les forces exercées par la goutte 16 sur le circuit intégré 10 déplacent alors le circuit intégré 10 jusqu'à l'alignement souhaité par rapport au plot 14 (figures 1C et 2C) sans qu'aucune action extérieure ne soit nécessaire.

Le procédé de fixation du circuit intégré 10 au support 11, par exemple par collage moléculaire ou par thermocompression, peut alors être mis en oeuvre.

Pour que le procédé d'auto-assemblage se déroule convenablement, il est nécessaire que la goutte 16 reste confinée sur le plot 14 tout au long de l'alignement du circuit intégré 10 par rapport au support 11. Dans l'exemple de procédé d'auto-assemblage décrit précédemment, le confinement de la goutte 16 sur le plot 14 tout au long du procédé d'auto-assemblage est obtenu par la différence de mouillabilité entre le plot 14 et le substrat 12. Plus la différence de mouillabilité est élevée, plus la goutte 16 tend à rester confinée sur le plot 14.

Toutefois, avec les procédés connus, il peut être difficile d'obtenir une différence de mouillabilité importante entre le plot 14 et le substrat 12. Il peut alors se produire des erreurs de placement de la goutte 16 sur le support 11 et la goutte 16 peut quitter le plot 14 au cours du procédé d'auto-assemblage.

Il existe donc un besoin de réalisation de plots pour l'auto-assemblage permettant d'améliorer le confinement de gouttes de liquide sur un support pour la mise en oeuvre d'un procédé d'auto-assemblage.

Il est, en outre, souhaitable que le procédé de fabrication des plots soit compatible avec les techniques classiques de fabrication de circuits électroniques.

US2009/265929 A1 divulgue un procédé comprenant la fabrication d'au moins un plot d'assemblage en oxyde de silicium sur un support et la mise en oeuvre d'un procédé d'auto-assemblage d'au moins une puce de circuit intégré sur le support, le procédé comprenant les étapes successives suivantes : exposer l'emplacement du plot d'assemblage à un traitement ultraviolet en présence d'ozone pour former le plot d'assemblage audit emplacement ; former, sur le support, une couche d'au moins un matériau fluorocarboné autour du plot d'assemblage ; déposer une goutte d'un liquide sur le plot d'assemblage ; amener la puce de circuit intégré au contact de la goutte, d'où il résulte un auto-assemblage de la puce de circuit intégré par rapport au plot d'assemblage sur le support ; faire sécher la goutte ; et fixer la puce de circuit intégré au support.

### Résumé

Un objet de l'invention est de pallier tout ou partie des inconvénients des procédés de fabrication de plots connus.

Un autre objet de la présente invention est d'améliorer le confinement de gouttes de liquide sur des plots d'un support pour la mise en oeuvre d'un procédé d'auto-assemblage.

Un autre objet de la présente invention est d'augmenter la différence de mouillabilité entre le plot et le substrat entourant le plot, pour la mise en oeuvre d'un procédé d'auto-assemblage.

Un autre objet de la présente invention est que le procédé de fabrication des plots est compatible avec les procédés classiques de fabrication de circuits intégrés.

La présente invention prévoit un procédé selon la revendication indépendante 1. Des exemples particuliers de réalisation de l'invention sont définis dans les revendications dépendantes.

### Brève description des dessins

Ces objets, caractéristiques et avantages, ainsi que d'autres seront exposés en détail dans la description suivante d'exemples de réalisation particuliers faite à titre non limitatif en relation avec les figures jointes parmi lesquelles :
les figures 1A à 1C, décrites précédemment, sont des coupes des structures obtenues à des étapes successives d'un exemple de procédé d'auto-assemblage ;
les figures 2A à 2C, décrites précédemment, sont des vues de dessus respectivement des figures 1A à 1C ;
les figures 3A à 3E sont des coupes, partielles et schématiques, des structures obtenues à des étapes successives d'un premier exemple de réalisation d'un procédé de fabrication selon l'invention d'un plot destiné à la mise en oeuvre d'un procédé d'auto-assemblage ;
la figure 4 est une coupe, partielle et schématique, d'une goutte de liquide reposant sur une protubérance illustrant l'effet d'ancrage de la goutte sur la protubérance ; et
les figures 5A à 5G sont des coupes, partielles et schématiques, des structures obtenues à des étapes successives d'un deuxième exemple de réalisation d'un procédé de fabrication selon l'invention d'un plot destiné à la mise en oeuvre d'un procédé d'auto-assemblage.

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

### Description détaillée

Selon l'invention, les plots destinés à la mise en oeuvre d'un procédé d'auto-assemblage sont réalisés en un matériau à mouillabilité élevée, pour lequel l'angle de contact statique d'une goutte de liquide sur le matériau est inférieur ou égal à 15°, de préférence inférieur ou égal à 10°, plus préférentiellement inférieur ou égal à 5°. Chaque plot est entouré par une région d'un matériau à mouillabilité faible, pour lequel l'angle de contact statique est supérieur ou égal à 100°, de préférence supérieur ou égal à 110°, plus préférentiellement supérieur ou égal à 115°.

Selon l'invention, les plots à mouillabilité élevée sont réalisés après les régions à mouillabilité faible entourant les plots. Le procédé de fabrication des régions à mouillabilité faible n'entraîne donc pas une réduction de la mouillabilité des plots à mouillabilité élevée. La mouillabilité élevée des plots est obtenue par un traitement sous un rayonnement ultra-violet en présence d'ozone. Pour que le procédé de fabrication des plots à mouillabilité élevée n'entraîne pas une augmentation de la mouillabilité des régions à mouillabilité faible déjà réalisées, les régions à mouillabilité faible sont réalisées par la formation d'une couche d'un matériau fluorocarboné. En effet, les inventeurs ont mis en évidence que la couche du matériau fluorocarboné conserve une mouillabilité faible même après lui avoir appliqué le traitement par rayonnement ultra-violet en présence d'ozone alors qu'un tel traitement entraîne généralement une augmentation de la mouillabilité des surfaces auxquelles il est appliqué.

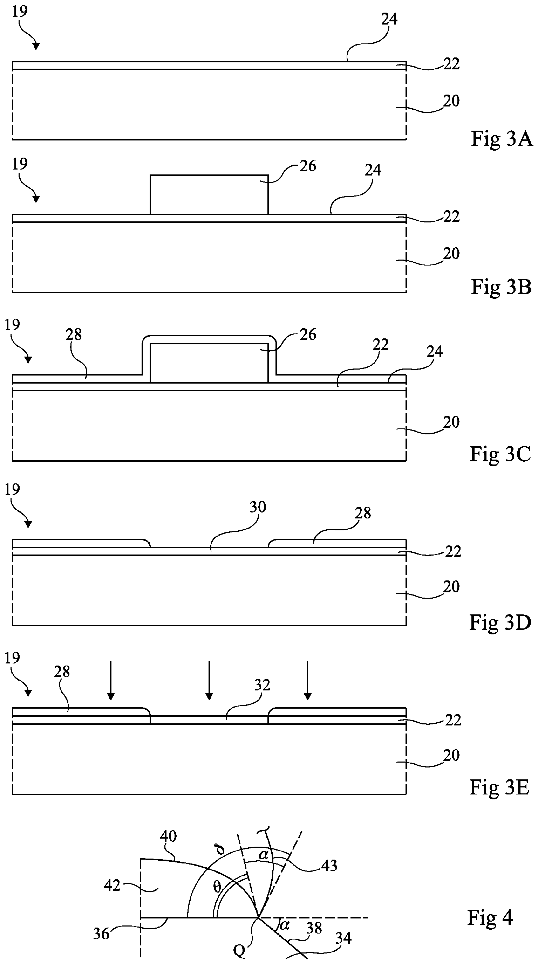

Les figures 3A à 3E représentent les structures obtenues à des étapes successives d'un premier exemple de réalisation d'un procédé de fabrication selon l'invention de plots sur un support destiné à la mise en oeuvre d'un procédé d'auto-assemblage. Sur les figures 3A à 3E, un seul plot est représenté. Il est clair que le premier exemple de réalisation du procédé de fabrication selon l'invention peut être mis en oeuvre pour réaliser simultanément plusieurs plots.

La figure 3A représente un support 19 comprenant un substrat 20 recouvert d'une couche isolante 22. Le substrat 20 peut être un substrat en un matériau semiconducteur, par exemple en silicium. La couche isolante 22 est alors une couche d'oxyde de silicium. L'épaisseur de la couche d'oxyde de silicium 22 peut être comprise entre 5 nm et 200 nm, par exemple de l'ordre de 50 nm. La surface libre de la couche 22 est désignée par la référence 24.

La figure 3B représente la structure obtenue après le dépôt d'une portion 26 d'une résine photosensible sur la surface 24. A titre d'exemple, l'épaisseur de la portion de résine 26 peut être comprise entre 500 nm et 3 µm, par exemple de l'ordre de 2,5 µm. La couche d'oxyde de silicium 22 facilite notamment l'accrochage de la résine. Le dépôt de la portion de résine 26 peut être réalisé par des étapes classiques de photolithographie comprenant :
le dépôt d'une couche de résine sur la totalité de la surface 24 ;
l'exposition de la couche de résine à un rayonnement au travers d'un masque pour reproduire dans la couche de résine des motifs du masque définissant le contour de la portion 26 ; et
la dissolution d'une partie de la couche de résine pour délimiter la portion 26.

La résine peut être une résine photosensible "positive". La partie de la résine exposée au rayonnement devient alors soluble dans une solution aqueuse ou organique spécifique, appelée solution de développement, et la partie de la résine non exposée reste insoluble dans la solution de développement. La résine peut être une résine photosensible "négative". La partie de la résine exposée au rayonnement devient alors insoluble dans la solution de développement et la partie de la résine non exposée reste soluble dans la solution de développement.

Des exemples de résine comprennent les composés suivants :
phénolformaldéhyde, par exemple un mélange de diazonaphtoquinone (ou DNQ) et d'une résine novolaque (résine de phénolformaldéhyde) ;
polyhydroxystyrène ;
poly(méthyl méthacrylate) ou PMMA ;
poly(méthyl glutarimide) ou PMGI ; et
polymère à base époxy (par exemple résine commercialisée sous l'appellation SU-8 par la société Micochem).

La figure 3C représente la structure obtenue après le dépôt d'une couche 28 à mouillabilité faible sur la totalité de la structure représentée en figure 3B, c'est-à-dire sur la portion de résine 26 et sur les parties de la couche d'oxyde de silicium 22 non recouvertes par la portion de résine 26. De façon avantageuse, il s'agit d'un dépôt conforme. L'épaisseur de la couche 28 est comprise entre 10 nm et 300 nm. La couche 28 est à base de composés fluorocarbonés. A titre d'exemple, la couche 28 est à base de composés fluorocarbonés de type CₓF_{y}, où x et y sont des nombres réels, x pouvant varier de 1 à 5 et y pouvant varier de 1 à 8.

Le dépôt de la couche 28 peut être réalisé en plaçant la structure représentée en figure 3B dans un plasma de passivation formé à partir d'octafluorobutène (C₄F₈), d'héxafluoroéthane (C₂F₆), de tétrafluorure de carbone (CF₄) et/ou de trifluorométhane (CHF₃). La durée d'exposition de la structure représentée en figure 3B au plasma peut être comprise entre 3 et 30 secondes.

A titre d'exemple, les gaz C₄F₈, C₂F₆, CF₄ et/ou CHF₃ peuvent être introduits dans la chambre d'un réacteur. Un plasma est alors formé à température ambiante, par exemple à environ 20°C, en appliquant un courant radiofréquence adapté à la chambre. La pression dans la chambre du réacteur est, par exemple, de 10 à 100 Pa. Le plasma à base du gaz C₄F₈, C₂F₆, CF₄ et/ou CHF₃ peut être formé dans un réacteur à plasma à couplage inductif ou ICP (acronyme anglais pour Inductively Coupled Plasma) avec un générateur radiofréquence.

La couche obtenue est à mouillabilité faible. L'angle de contact statique est supérieur ou égal à 110°, de préférence supérieur ou égal à 115°.

La mesure de l'angle de mouillage peut être réalisée en utilisant l'appareil de mesure commercialisé par la société GBX sous l'appellation Digidrop - MCAT. La mesure comprend le dépôt d'une goutte d'eau déminéralisée de 2 à 10 µl sur une surface du matériau à étudier, l'acquisition d'une image de la goutte par un dispositif d'acquisition d'images et la détermination de l'angle de contact par une analyse par ordinateur de l'image acquise.

La figure 3D représente la structure obtenue après le retrait de la portion de résine 26 de façon à exposer la portion 30 de la couche d'oxyde de silicium 22 qui était recouverte par la portion de résine 26. L'étape de retrait peut être réalisée en plaçant la structure obtenue à l'étape 3C dans un bain d'un solvant adapté à dissoudre la résine. La durée du traitement dans le bain est, par exemple, comprise entre 40 secondes et 1 minute. Le solvant est, par exemple, l'acétone ou le N-méthyl-2-pyrrolidone. De façon avantageuse, des ultrasons sont appliqués au support 19 pendant son immersion dans le bain. A titre d'exemple, la longueur d'onde des ultrasons est comprise entre 45 kHz et 47 kHz.

La figure 3E représente la structure obtenue après un traitement entraînant une augmentation de la mouillabilité de la portion 30 exposée pour former un plot 32 à mouillabilité élevée destiné à la mise en oeuvre d'un procédé d'auto-assemblage. Le traitement comprend l'exposition de la totalité de la structure représentée en figure 3C à un rayonnement ultraviolet en présence d'ozone. Le rayonnement ultraviolet comprend un premier rayonnement ultraviolet à une première longueur d'onde comprise entre 182 nm et 187 nm, par exemple de l'ordre de 184,9 nm, et un deuxième rayonnement ultraviolet à une deuxième longueur d'onde comprise entre 250 nm et 255 nm, par exemple de l'ordre de 253,7 nm. Le premier rayonnement permet notamment d'altérer les composés hydrocarbonés présents sur la portion 30. Le deuxième rayonnement permet notamment de former des radicaux actifs à partir de l'ozone, ces radicaux actifs réagissant avec les composés hydrocarbonés pour former des composés volatils qui sont évacués. Le traitement peut être mis en oeuvre à une température de l'ordre de 80°C dans une enceinte contenant initialement de l'ozone. Ce traitement UV peut être réalisé à la pression atmosphérique.

L'angle de contact d'une goutte de liquide, par exemple de l'eau déminéralisée, sur le plot 32 est inférieur ou égal à 15°, de préférence inférieur ou égal à 10°, plus préférentiellement inférieur ou égal à 5°, alors que l'angle de contact d'une goutte de liquide, par exemple de l'eau déminéralisée, sur la portion 30 avant le traitement au rayonnement ultraviolet en présence d'ozone, est compris entre 20° et 30°. La différence de mouillabilité entre la portion 32 et la couche 28 adjacente est donc supérieure ou égale à 85°, de préférence supérieure ou égale à 90°, plus préférentiellement supérieure ou égale à 100°, ce qui assure un confinement convenable d'une goutte de liquide, notamment de l'eau déminéralisée, sur le plot 32.

Selon un deuxième exemple de réalisation de procédé de fabrication du plot d'auto-assemblage, le plot est formé au sommet d'une protubérance dont les flancs forment une arête vive avec le plot. Ceci permet de bénéficier, en plus de la différence de mouillabilité entre le plot et la région entourant le plot, d'un effet d'ancrage de la goutte sur le sommet de la protubérance pour maintenir la goutte confinée sur le plot.

La figure 4 illustre l'effet d'ancrage et représente une protubérance 34 comprenant un sommet 36 plan et horizontal et un flanc incliné 38. Dans le plan de coupe de la figure 4, le sommet 36 et le flanc 38 se rejoignent au point Q. Le flanc 38 est incliné d'un angle α par rapport à l'horizontale. L'angle α est égal à 0° en l'absence d'inclinaison. On a représenté en figure 4 l'interface 40 liquide-air d'une goutte 42 lorsque l'angle α est égal à 0°. Au repos, l'angle entre le sommet 36 et la tangente à l'interface 40 au point Q est alors égal à l'angle de contact statique θ. En l'absence de flanc incliné 38, si on ajoute du liquide à la goutte 42, l'interface 40 tend à se déplacer et franchir le point Q, l'angle de contact restant constant. En présence du flanc incliné 38, l'angle δ entre le sommet 36 et la tangente à l'interface 43, pour lequel la goutte 42 franchit le point Q, est égal à la somme des angles θ et α. Tout se passe comme si la goutte 42 restait ancrée au sommet 36 de la protubérance 34.

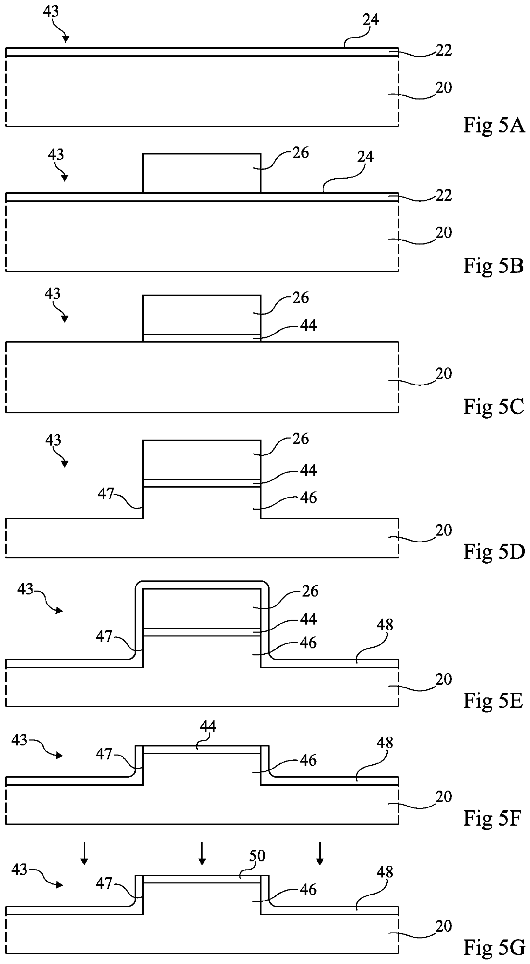

Les figures 5A à 5G illustrent les structures obtenues à des étapes successives du deuxième exemple de réalisation d'un procédé de fabrication selon l'invention de plots d'un support 43 destiné à la mise en oeuvre d'un procédé d'auto-assemblage. Sur les figures 5A à 5G, un seul plot est représenté. Il est clair que le second exemple de réalisation du procédé de fabrication selon l'invention peut être mis en oeuvre pour réaliser simultanément plusieurs plots.

Les figures 5A et 5B sont identiques aux figures 3A et 3B décrites précédemment.

La figure 5C représente la structure obtenue après une étape de gravure de la couche d'oxyde de silicium 22 autour de la portion de résine 26. Il reste alors une portion 44 de la couche d'oxyde de silicium 22 sous la portion de résine 26. La gravure peut être une gravure par ions réactifs ou RIE (acronyme anglais pour Reactive Ion Etching). Le gaz de gravure peut être l'acide fluorhydrique (HF) ou le fluorure d'ammonium (NH₄F). Le substrat 20 de silicium peut jouer le rôle de couche d'arrêt de gravure.

La figure 5D représente la structure obtenue après une étape de gravure du substrat 20 pour former une protubérance 46 dans le prolongement de la portion de résine 26 et de la portion d'oxyde de silicium 44. La hauteur de la protubérance 46 peut être comprise entre 500 nm à 80 µm. La protubérance 46 comprend des flancs inclinés 47 sensiblement perpendiculaires à la face supérieure de la portion 44. A titre de variante, les flancs 47 peuvent être inclinés par rapport à la face supérieure de la portion 44 d'un angle α (voir figure 4) compris entre 0° et 90°, de préférence entre 45° et 90°.

La gravure est une gravure anisotrope, la portion de résine 26 jouant le rôle d'un masque de gravure. Il peut s'agir d'une gravure profonde par ions réactifs ou DRIE (acronyme anglais pour Deep Reactive Ion Etching). Le gaz de gravure peut être l'hexafluorure de soufre (SF₆). Dans ce cas, la hauteur de la protubérance 46 est de préférence inférieure à quelques micromètres. La gravure peut être réalisée selon le procédé Bosch. Dans ce cas, la hauteur de la protubérance 46 est de préférence supérieure à quelques micromètres.

Le procédé Bosch comprend l'exposition du support 43 à une alternance d'un plasma de gravure et d'un plasma de passivation à température ambiante. Le plasma de gravure est formé à partir d'hexafluorure de soufre (SF₆). Des radicaux fluorés se forment et réagissent avec le silicium pour créer des espèces volatiles, notamment du tétrafluorosilane (SiF₄). Le plasma de passivation est formé à partir de d'octafluorobutène (C₄F₈), d'héxafluoroéthane (C₂F₆), de tétrafluorure de carbone (CF₄) et/ou de trifluorométhane (CHF₃). Le plasma de gravure grave de manière isotrope le silicium, la portion de résine 26 jouant le rôle d'un masque de gravure. Après une exposition du support 43 au plasma de gravure, le support 43 est exposé au plasma de passivation qui entraîne le dépôt d'une couche de protection sur les flancs de la zone gravée et sur le fond de la zone gravée en déposant une couche d'un polymère fluorocarboné. L'épaisseur du dépôt de passivation est conditionnée par les paramètres du plasma de passivation. L'étape de gravure suivante détruit la couche de passivation au fond de la zone gravée à l'aide du bombardement ionique. Le silicium non protégé par la couche de passivation est alors gravé dans cette même étape par les radicaux fluorés provenant du plasma de gravure. En augmentant le nombre d'alternances des étapes de gravure et de passivation, une gravure profonde anisotrope peut être alors obtenue.

A titre d'exemple, les gaz SF₆, C₄F₈, C₂F₆, CF₄ et/ou CHF₃ peuvent être introduits dans la chambre d'un réacteur. Un plasma est alors formé à température ambiante, par exemple à environ 20°C, en appliquant un courant radiofréquence adapté à la chambre. La pression dans la chambre du réacteur est, par exemple, de 10 à 100 Pa. La pression partielle du gaz de gravure SF₆ est, par exemple, de l'ordre de 20 mTorr (2,67 Pa). Le plasma de gravure à base du gaz SF₆ et le plasma de passivation à base des gaz C₄F₈, C₂F₆, CF₄ et/ou CHF₃ peuvent être formés dans un réacteur à plasma à couplage inductif.

La figure 5E représente la structure obtenue après le dépôt d'une couche 48 à mouillabilité faible sur la totalité de la structure représentée en figure 5D. En particulier, la couche 48 recouvre les flancs 47 de la protubérance 46. Le dépôt de la couche 48 peut être réalisé comme cela a été décrit précédemment en relation avec la figure 3C pour le dépôt de la couche 28. L'épaisseur de la couche 48 est comprise entre 10 nm et 300 nm. La couche 48 est à base de composés fluorocarbonés. A titre d'exemple, la couche 48 est à base de composés fluorocarbonés de type CₓF_{y}, où x et y sont des nombres réels, x pouvant varier de 1 à 5 et y pouvant varier de 1 à 8.

La figure 5F représente la structure obtenue après une étape de retrait de la portion de résine 26 de façon à exposer la portion 44. Ceci peut être réalisé comme cela a été décrit précédemment en relation avec la figure 3D en plaçant la structure représentée à l'étape 5E dans un bain d'un solvant et en appliquant des ultrasons au support 43 pendant son immersion dans le bain.

La figure 5G représente la structure obtenue après un traitement entraînant une augmentation de la mouillabilité de la portion 44 exposée pour former le plot 50 destiné à la mise en oeuvre d'un procédé d'auto-assemblage. Ceci est réalisé comme cela a été décrit précédemment en relation avec la figure 3E en exposant la totalité de la structure représentée à la figure 5F à un rayonnement ultraviolet en présence d'ozone.

L'angle de contact d'une goutte d'un liquide, par exemple de l'eau déminéralisée, sur le plot 50 est inférieur ou égal à 15°, de préférence inférieur ou égal à 10°, plus préférentiellement inférieur ou égal à 5°. En outre, l'angle entre les flancs 47 recouverts de la couche 48 à mouillabilité faible et le plot 50 permet de bénéficier de l'effet d'ancrage décrit précédemment. Le confinement d'une goutte de liquide sur le plot 50 est donc amélioré.

Le procédé de fabrication selon l'invention est particulièrement adapté dans le cas où la fixation du circuit intégré au support 19, 43, qui est réalisée après l'auto-assemblage, est effectuée par collage moléculaire. En effet, pour ce type de fixation, il est nécessaire de prévoir des surfaces avec une rugosité adaptée. Les exemples de procédé de fabrication décrits précédemment permettent d'obtenir des plots 32, 50 dont la rugosité moyenne quadratique RMS est par exemple comprise entre 0,2 nm et 0,5 nm (mesurée sur une surface de mesure de 1 µm²), c'est-à-dire adaptée à un procédé de collage moléculaire. En outre, la portion 50 ayant une mouillabilité élevée, elle est adaptée à la réalisation d'un collage moléculaire hydrophile.

Des modes de réalisation particuliers de la présente invention ont été décrits. Diverses variantes et modifications apparaîtront à l'homme de l'art. En particulier, dans les exemples de réalisation décrits précédemment, le substrat 20 est en un matériau semiconducteur, par exemple en silicium. A titre de variante, le substrat 20 peut être un substrat en verre ou un substrat métallique. Dans ce cas, la couche isolante 22 peut ne pas être présente. Le substrat 20 peut être un substrat composite, comprenant en surface des éléments en un matériau semiconducteur, des éléments en un matériau métallique et/ou des éléments en un matériau isolant. Dans ce cas, la couche isolante 22 peut ne recouvrir que les éléments en matériau semiconducteur.

## Revendications

1. Procédé comprenant la fabrication d'au moins un plot d'assemblage (32 ; 50) en oxyde de silicium sur un support (19 ; 43) et la mise en oeuvre d'un procédé d'auto-assemblage d'au moins une puce de circuit intégré (10) sur le support (19; 43), le procédé comprenant les étapes successives suivantes :
(a) former, sur le support (19; 43), une couche (28 ; 48) d'au moins un matériau fluorocarboné autour de l'emplacement du plot d'assemblage (32; 50), la couche (28; 48) ayant une épaisseur supérieure à 10 nm et inférieure à 300 nm ; et
(b) exposer la couche (28; 48) et l'emplacement à un traitement ultraviolet en présence d'ozone pour former le plot d'assemblage (32; 50) audit emplacement entouré de ladite couche (28; 48), une goutte d'un liquide ayant un angle de contact statique sur le plot d'assemblage (32; 50) inférieur ou égal à 15°, une goutte du liquide ayant, après l'étape (b), un angle de contact statique sur la couche (28; 48) supérieur ou égal à 100° ;
(c) déposer une goutte (16) du liquide sur le plot d'assemblage (32 ; 50) ;
(d) amener la puce de circuit intégré (10) au contact de la goutte (16), d'où il résulte un auto-assemblage de la puce de circuit intégré (10) par rapport au plot d'assemblage (32; 50) sur le support (19 ; 43) ;
(e) faire sécher la goutte (16) ; et
(f) fixer la puce de circuit intégré (10) au support (19 ; 43).

2. Procédé selon la revendication 1, dans lequel l'étape (a) comprend l'exposition du support (19 ; 43) à un plasma formé à partir d'octafluorobutène, d'héxafluoroéthane, de tétrafluorure de carbone et/ou de trifluorométhane.

3. Procédé selon la revendication 1 ou 2, comprenant, en outre, les étapes suivantes :
(g) former une portion de résine (26) sur le support (19 ; 43) audit emplacement avant l'étape (a) ; et
(h) retirer la portion de résine (26) après l'étape (a) et avant l'étape (b).

4. Procédé selon la revendication 3, comprenant, en outre, après l'étape (g) et avant l'étape (a), une étape de gravure du support (19 ; 43) pour former une protubérance (46) sous la portion de résine (26).

5. Procédé selon l'une quelconque des revendications 1 à 4, dans lequel le support (19 ; 43) comprend un substrat (20) en silicium sur lequel est formée la couche (28 ; 48) du matériau fluorocarboné, le procédé comprenant, en outre, une étape de formation d'une couche d'oxyde de silicium (22) sur le substrat (20) avant l'étape (a), une portion de la couche d'oxyde de silicium (22) entourée de la couche du matériau fluorocarboné (28 ; 48) formant le plot d'assemblage (32 ; 50).

6. Procédé selon l'une quelconque des revendications 1 à 5, dans lequel l'étape (f) comprend une étape de collage moléculaire de la puce de circuit intégré (10) au plot d'assemblage (32 ; 50).

## Patentansprüche

1. Verfahren, das die Herstellung wenigstens eines Anordnungspads (32; 50) aus Siliziumoxid auf einem Träger (19; 43) und die Durchführung eines Verfahrens zur Selbstanordnung wenigstens eines integrierten Schaltungschips (10) auf dem Träger (19; 43) aufweist, wobei das Verfahren die aufeinanderfolgenden Schritte aufweist:
(a) Ausbilden einer Schicht (28; 48) aus wenigstens einem Fluorkohlenstoffmaterial auf dem Träger (19; 43) um die Position des Anordnungspads (32; 50) herum, wobei die Schicht (28; 48) eine Dicke von mehr als 10 nm und weniger als 300 nm aufweist; und
(b) Aussetzen der Schicht (28; 48) und der Position einer Ultraviolettverarbeitung in der Gegenwart von Ozon, um das Anordnungspad (32; 50) an der von der Schicht (28; 48) umgebenen Stelle auszubilden, eines Tropfens einer Flüssigkeit mit einem statischen Kontaktwinkel auf dem Anordnungspad (32; 50), der niedriger oder gleich 15° ist, eines Tropfens der Flüssigkeit, der nach Schritt b) einen statischen Kontaktwinkel auf der Schicht (28; 48), der höher oder gleich 100° ist;
(c) Abscheiden eines Tropfens (16) der Flüssigkeit auf das Anordnungspad (32; 50);
(d) In-Kontakt-bringen des integrierten Schaltungschips (10) mit dem Tropfen (16), wodurch der integrierte Schaltungschip (10) in Bezug auf das Anordnungspad (32; 50) auf dem Träger (19; 43) selbst angeordnet ist;
(e) Trocknen des Tropfens (16); und
(f) Bonden des integrierten Schaltungschips (10) mit dem Träger (19; 43).

2. Verfahren nach Anspruch 1, wobei Schritt (a) das Aussetzen des Trägers (19; 43) gegenüber einem Plasma basierend auf Octafluorobuten, Hexafluorethan, Kohlenstofftetrafluorid und/oder Trifluormethan aufweist.

3. Verfahren nach Anspruch 1 oder 2, das ferner folgende Schritte aufweist:
(g) Ausbilden eines Harzteils (26) auf dem Träger (19; 43) an der Stelle vor Schritt (a); und
(h) Entfernen des Harzteils (26) nach Schritt (a) und vor Schritt (b).

4. Verfahren nach Anspruch 3, das ferner nach Schritt (g) und vor Schritt (a), einen Schritt des Ätzens des Trägers (19; 43) aufweist, um einen Vorsprung (46) unter dem Harzteil (26) auszubilden.

5. Verfahren nach einem der Ansprüche 1 bis 4, wobei der Träger (19; 43) ein Siliziumsubstrat (20) mit der darauf ausgebildeten Fluorkohlenstoff-Materialschicht (28; 48) aufweist, wobei das Verfahren ferner einen Schritt zum Ausbilden einer Oxid-Siliziumschicht (22) auf dem Substrat vor Schritt (a) aufweist, wobei ein Teil der Oxid-Siliziumschicht (22) von der Fluorkohlenstoff-Materialschicht (28; 48) umgeben ist, die das Anordnungspad (32; 50) ausbildet.

6. Verfahren nach einem der Ansprüche 1 bis 5, wobei Schritt (f) einen Schritt des molekularen Bondens des integrierten Schaltungschips (10) an das Anordnungspad (32; 50) aufweist.

## Claims

1. A method comprising the manufacture of at least one assembly pad (32; 50) made of silicon oxide on a support (19; 43) and the implementation of a method of self-assembly of at least one integrated circuit chip (10) on the support (19; 43), the method comprising the successive steps of:
(a) forming, on the support (19; 43), a layer (28; 48) of at least one fluorocarbon material around the location of the assembly pad (32; 50), the layer (28; 48) having a thickness higher to 10 nm and lower to 300 nm; and
(b) submitting the layer (28; 48) and the location to an ultraviolet processing in the presence of ozone to form the assembly pad (32; 50) at said location surrounded with said layer (28; 48), a drop of a liquid having a static contact angle on the assembly pad (32; 50) lower or equal to 15°, a drop of the liquid having, after step b), a static contact angle on the layer (28; 48) higher or equal to 100°;
(c) depositing a drop (16) of the liquid on the assembly pad (32; 50);
(d) bringing the integrated circuit chip (10) in contact with the drop (16), whereby the integrated circuit chip (10) is self-assembled with respect to the assembly pad (32; 50) on the support (19; 43);
(e) drying the drop (16); and
(f) bonding the integrated circuit chip (10) to the support (19; 43).

2. The method of claim 1, wherein step (a) comprises exposing the support (19; 43) to a plasma based on octafluorobutene, hexafluoroethane, carbon tetrafluoride, and/or trifluoromethane.

3. The method of claim 1 or 2, further comprising the steps of:
(g) forming a resin portion (26) on the support (19; 43) at said location before step (a); and
(h) removing the resin portion (26) after step (a) and before step (b).

4. The method of claim 3, further comprising, after step (g) and before step (a), a step of etching the support (19; 43) to form a protrusion (46) under the resin portion (26).

5. The method of any of claims 1 to 4, wherein the support (19; 43) comprises a silicon substrate (20) having the fluorocarbon material layer (28; 48) formed thereon, the method further comprising a step of forming an oxide silicon layer (22) on the substrate before step (a), a portion of the oxide silicon layer (22) surrounded by the fluorocarbon material layer (28; 48) forming the assembly pad (32; 50).

6. The method of any of claims 1 to 5, wherein step (f) comprises a step of molecular bonding of the integrated circuit chip (10) to the assembly pad (32; 50).
